# EUROPEAN PATENT APPLICATION

(11) **EP 4 564 396 A1**
(43) Date of publication of application: **04.06.2025**
(21) Application number: 23213449.4
(22) Date of filing: 30.11.2023
(51) Int. Cl.: H01J 37/09, H01J 37/12, H01J 37/244, H01J 37/28, H01J 37/317

(54) **ELECTRON-OPTICAL SYSTEM, METHOD OF MANUFACTURING AN ELECTRON BEAM ELEMENT**

(71) Applicant: ASML Netherlands B.V., 5500 AH Veldhoven (NL)
(72) Inventor: WALVOORT, Derk, Ferdinand, 5500 AH Veldhoven (NL); LOOMAN, Bram, Albertus, 5500 AH Veldhoven (NL); MUDRETSOV, Dmitry, 5500 AH Veldhoven (NL)
(74) Representative: ASML Netherlands B.V.

(57) **Abstract**

The disclosure relates to electron-optical systems and associated methods. In one arrangement, the system comprises an electron beam element comprising a substrate in which at least one aperture is defined for passage of a respective electron beam. The aperture comprises an entrance opening and an exit opening. A cross-section of the entrance opening has an entrance shape that is distorted relative to a target shape. A cross-section of the exit opening has an exit shape that is also distorted relative to the target shape. When scaled to have the same cross-sectional area as each other, the entrance and exit shapes comprise deviations relative to the target shape that are opposite in sign along at least one direction perpendicular to an aperture axis.

## Description

### FIELD

The present disclosure relates to an electron-optical system and a method of manufacturing an electron beam element.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which may be referred to as assessment apparatuses or assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface it is possible to obtain an image representing characteristics of the material structure of the surface of the sample.

Electron-optical systems may comprise electron beam elements having apertures to control beams of electrons. Electric fields adjacent to the apertures may be controlled to influence trajectories of the electrons, such as by providing lensing effects, deflection effects and/or corrections. Various aspects of the apertures may affect electron-optical performance, such as shapes, sizes and/or positions of the apertures. Imperfections in a manufacturing process used to manufacture the apertures can reduce performance of an electron-optical system, for example by increasing aberrations in the beams and thereby reducing resolution.

### SUMMARY

It is an object of the present disclosure to provide apparatus and methods that contribute to improving the electron-optical performance of electron-optical systems.

According to an aspect of the invention, there is provided an electron-optical system for projecting one or more electron beams towards a sample, the system comprising an electron beam element for operating on the one or more electron beams, wherein the electron beam element comprises: a substrate in which at least one aperture is defined for passage of a respective electron beam through the aperture, the aperture having an aperture axis, wherein: the aperture comprises an entrance opening and an exit opening on opposite sides of the substrate; a cross-section of the entrance opening across the aperture axis has an entrance shape, the entrance shape being distorted relative to a target shape; a cross-section of the exit opening across the aperture axis has an exit shape, the exit shape being distorted relative to the target shape; and when the entrance shape, the exit shape, and the target shape are scaled to have the same cross-sectional area as each other, the entrance shape and the exit shape comprise deviations relative to the target shape that are opposite in sign along at least one direction perpendicular to the aperture axis; and/or when the entrance shape, the exit shape, the target shape and cross-sections of the aperture are scaled to have the same cross-sectional area as each other, a cross-section of the aperture varies as a function of position along the aperture axis such that an azimuthal distortion function defining a shape of the cross-section changes sign at a position between the entrance opening and the exit opening, the azimuthal distortion function defining a deviation as a function of azimuthal angle between the shape of the cross-section and the target shape.

According to an alternative aspect of the invention, there is provided a method of manufacturing an electron beam element for operating on one or more electron beams of an electron-optical system, the method comprising: etching at least one aperture in a substrate for passage of a respective electron beam through the aperture, the aperture having an aperture axis, wherein the etching is configured to remove material progressively from a first side of the substrate to a second side of the substrate to define a respective start opening and end opening of the aperture, wherein: a cross-section of the start opening across the aperture axis has a start shape, the start shape being distorted relative to a target shape; a cross-section of the end opening across the aperture axis has an end shape, the end shape being distorted relative to the target shape; and when the start shape, the end shape, and the target shape are scaled to have the same cross-sectional area as each other, the start shape and the end shape comprise deviations relative to the target shape that are opposite in sign along at least one direction perpendicular to the aperture axis; and/or when the start shape, the end shape, the target shape and cross-sections of the aperture are scaled to have the same cross-sectional area as each other, a cross-section of the aperture varies as a function of position along the aperture axis such that an azimuthal distortion function defining a shape of the cross-section changes sign at a position between the start opening and the end opening, the azimuthal distortion function defining a deviation as a function of azimuthal angle between the shape of the cross-section and the target shape.

According to an alternative aspect of the invention, there is provided a method of manufacturing an electron beam element for operating on one or more electron beams of an electron-optical system, the method comprising: etching an aperture in a substrate for passage of an electron beam through the aperture, wherein the etching comprises removing material progressively from a start side of the substrate at a first opening with a start shape to an end side of the substrate at a second opening with an end shape, the etching applying a radial distortion to the start shape with progress towards the second opening, wherein the start shape and the end shape are derived by application of the radial distortion with opposite sign with respect to a target shape, the target shape being optionally circular, elliptical, a polygon, and/or a regular shape.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1**.
**FIG. 3** is a schematic diagram of an exemplary electron-optical device comprising a condenser lens array, an objective lens array and a detector array.
**FIG. 4** is a schematic cross-sectional view of a portion of an objective lens array and detector array of an exemplary arrangement.
**FIG. 5** is bottom view of the portion of the detector array of **FIG. 4**.
**FIG. 6** is a schematic diagram of an exemplary electron-optical device comprising an objective lens array and a beam separator.
**FIG. 7** is a diagram of a further exemplary electron-optical device.
**FIG. 8** is a schematic diagram of an exemplary electron-optical stack that may be part of the electron-optical devices of, for example, **FIG. 3**, **6** and **7**.
**FIG. 9** is a schematic perspective view of an electron beam element of an exemplary electron-optical stack.
**FIG. 10** depicts an entrance shape (left) and an exit shape (right) of an aperture in a case where no distortion is applied to the entrance shape relative to a target shape.
**FIG. 11** is a schematic side sectional view of a portion of an electron beam element.
**FIG. 12** depicts an example distorted entrance shape of an aperture relative to a circular target shape.
**FIG. 13** depicts an example distorted exit shape of the aperture of **FIG. 12** relative to the same target shape.
**FIG. 14** depicts the entrance shape and target shape of **FIG. 12** with superposed arrows schematically depicting radial deviations of the entrance shape relative to the target shape.
**FIG. 15** depicts the exit shape and target shape of **FIG. 13** with superposed arrows schematically depicting radial deviations of the exit shape relative to the target shape.
**FIG. 16** depicts an entrance shape (left) and an exit shape (right) of an aperture in a case in which a distortion relative to a target shape is equal in magnitude and opposite in sign for the entrance shape and the exit shape, such that a distortion is shared equally between the entrance shape and the exit shape; the entrance shape is a rotated version of the exit shape.
**FIG. 17** depicts an entrance shape of an aperture and a corresponding elliptical target shape, with superposed arrows schematically depicting deviations of the entrance shape relative to the target shape.
**FIG. 18** depicts an exit shape and target shape corresponding to the aperture of **FIG. 17**, with superposed arrows schematically depicting deviations of the exit shape relative to the target shape.
**FIG. 19** depicts an alternative target shape that comprises a plurality of radial outward portions.
**FIG. 20** depicts an example distorted entrance shape corresponding to the target shape of **FIG. 19**.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

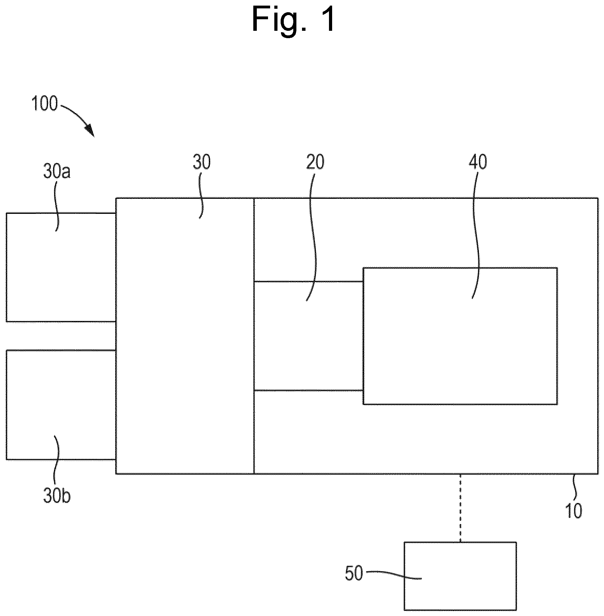

Reference is now made to **FIG. 1**, which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include one or more additional loading ports. First loading port 30a and second loading port 30b may, for example, receive substrate front opening unified pods (FOUPs) that contain substrates (e.g., semiconductor substrates or substrates made of other materials) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

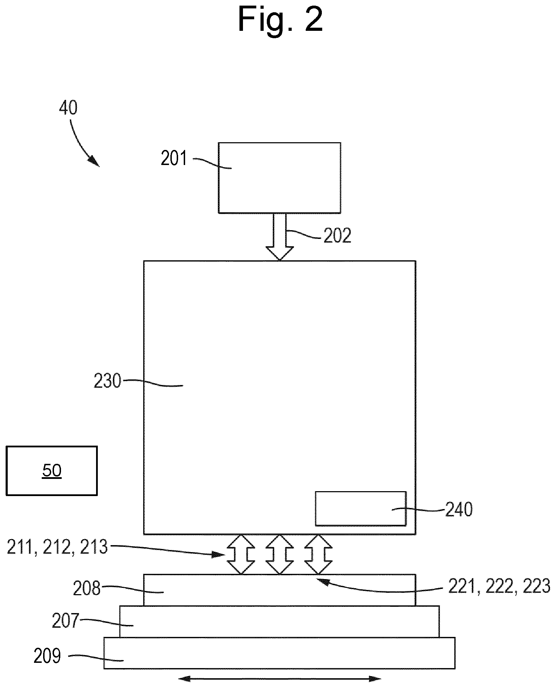

Reference is now made to **FIG. 2**, which is a schematic diagram illustrating an exemplary electron beam apparatus 40. The electron beam apparatus 40 may be provided as part of the exemplary charged particle beam inspection system 100 of **FIG. 1**. The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

The controller 50 (for example control system comprising distributed controllers) may be connected to various parts of charged particle beam inspection apparatus 100 of **FIG. 1**, such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (^ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EP4086933A1, which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

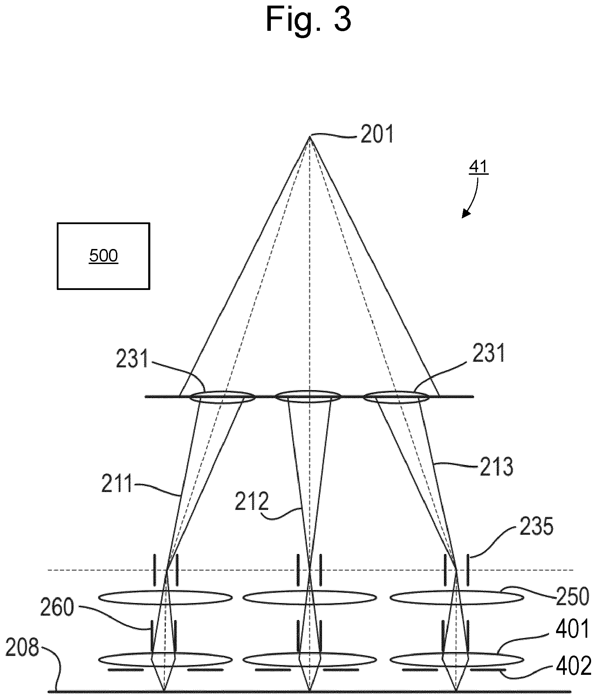

**FIG. 3** is a schematic diagram of an exemplary electron-optical device 41 (which may also be referred to as a charged particle device) for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of electron-optical device 41. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. The collimators may be configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 401 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam. The detector module may comprise at least one of scintillator elements, semiconducting elements or charge capture electrodes, for example to capture signal electrons as current.

The electron-optical device 41 of **FIG. 3** may be configured to control the landing energy of electrons on the sample 208 by varying potentials applied to the electrodes of the control lenses and the objective lenses. The electrodes may comprise plates and be referred to as plates or electron-optical plates. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

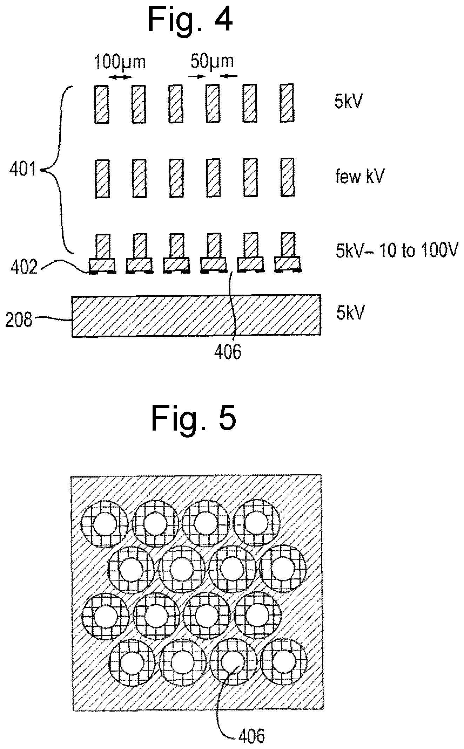

An exemplary embodiment of a detector integrated into an objective lens array 401 is shown in **FIG. 4**, which illustrates a portion of an objective lens array 401 in schematic cross section. In this embodiment, the detector comprises a detector module 402 comprising a plurality (e.g., an array) of detector elements 405, shown in **FIG. 5** (e.g., sensor elements such as capture electrodes), preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5**, the beam apertures 406 are shown in a hexagonal array, for example as a hexagonal close packed array. The beam apertures 406 can also be differently arranged, e.g. in a rectangular array .

The integrated detector module 402 described above is particularly advantageous when used with an assessment apparatus (e.g. comprising an electron-optical device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP3937204A1, which document is hereby incorporated by reference.

An electric power source may be provided to apply respective potentials to any of the electrodes of the device 41, for example of the control lenses of, for example, the control lens array 250 and the objective lenses of the objective lens array 401 and the condenser lenses of the condenser lens array or any other electron-optical element or component of the electron-optical device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The electron-optical device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the electron-optical device 41.

In an embodiment, an array of electron-optical devices (or device array) is provided. The array may comprise a plurality of any of the electron-optical devices (e.g., electron-optical columns or charged particle devices) described herein. Each of the electron-optical devices in the array focuses respective pluralities of charged particle beams onto different regions of the same sample 208. Each electron-optical device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different electron-optical devices simultaneously onto different regions of the same sample allows an increased area of the sample 208 to be exposed to charged particle beams simultaneously. Therefore, an increased area of the sample may be processed (e.g. assessed) at one time. The electron-optical devices in the device array may be arranged adjacent to each other so as to project the respective pluralities of beams onto adjacent regions of the sample 208. Any number of electron-optical devices may be used in the array. Preferably, the number of electron-optical devices is in the range of 9 to 200. Each electron-optical device in the device array may be configured in any of the ways described herein when referring to a single electron-optical device, charged particle device or system or column. Alternatively or additionally, one or more of the electron-optical devices in the array may be configured to project a single beam.

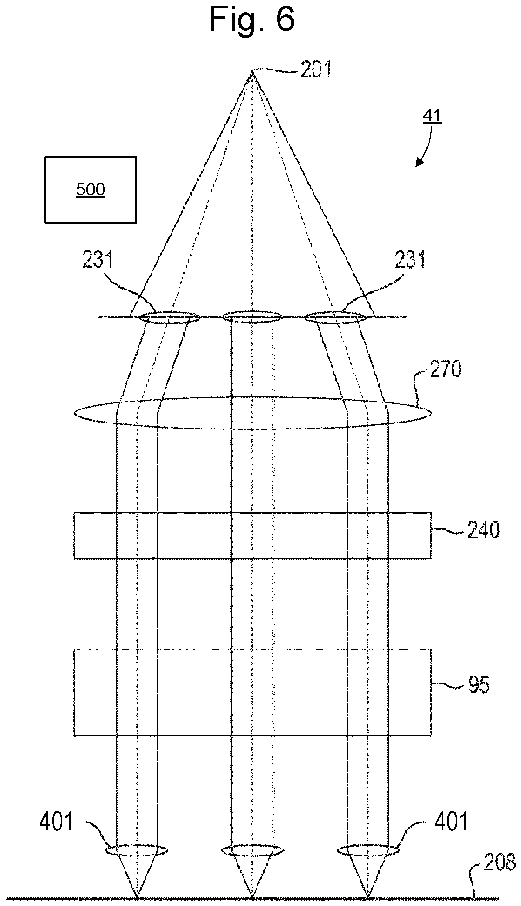

**FIG. 6** schematically depicts a further example of an electron-optical device 41. Features that are the same as those described above are given the same reference numerals. For conciseness, such features are not described in detail with reference to **FIG. 6**. For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3**. Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 6**, the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic field. The electrostatic and magnetic fields operate together to separate the charged particles projected to the sample 208 relative to the signal particles e.g. electrons from the sample 208. The electric field may be across the beam path at a position along the beam path down beam of the magnetic field. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

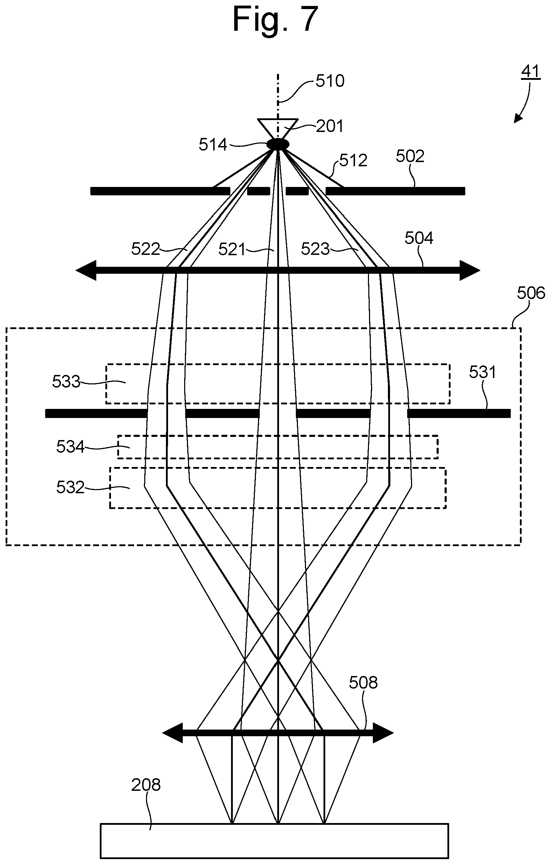

**FIG.** 7 is a schematic diagram of a further exemplary electron-optical device 41 for use in an assessment apparatus. The electron-optical device 41 may be used in combination with any of the embodiments described herein, for example instead of any of the electron-optical devices 41 described above, such as with reference to **FIG. 3** and/or **FIG. 6**. In this example, the electron-optical device 41 comprises an electron source 201, a beam-forming aperture array 502, a condenser lens 504, a source conversion unit 506, an objective lens 508, and a sample 208. The source 201 and the sample 208 may take any of the forms described above with reference for example to **FIG. 2**, **3** and **6** for example. The source 201, beam-forming aperture array 502, condenser lens 504, source conversion unit 506, and objective lens 508 may be aligned with a primary electron-optical axis 510 of the charged particle device 41. The source 201 generates a primary electron beam 512 with a source cross-over 514. The beam-forming aperture array 502 forms beams 521, 522, 523 from the primary beam 512. A line of three beams is depicted but the beam-forming aperture array 502 may be configured to form a line of two beams or a line of more than three beams, such as a line of four beams or a line of five beams. The beam-forming aperture array 502 may also be configured to form multiple lines of beams, thereby forming an array of beams. For example, the beam-forming aperture array 502 may be configured to form an *n* × *m* array of beams where *n* and *m* are integers that may be the same or different, such as a 3 × 3 array of beams, a 4 × 4 array of beams, or a 5 × 5 array of beams. In a different arrangement, the array of apertures has a hexagonal array of beam apertures.

The condenser lens 504 may be configured to re-direct paths of the beams 521, 522, 523 to be substantially parallel to each other and/or to be incident substantially perpendicularly onto the source conversion unit 506. The condenser lens 504 may be a macro magnetic lens arrangement such as a multiple, e.g. two, lenses set at a non-rotational setting (by which the rotational effect of the different lenses of the lens arrangement cancel or their net rotational effect on the paths of the beams is substantially zero).

The source conversion unit 506 may include a beam-limiting aperture array 531 defining apertures configured to laterally limit each of the beams 521, 522, 523. The beam-limiting aperture array 531 may shape one more of the beams 521, 522, 523 for example to separate the beams into two or more beams down beam of the beam-limiting aperture array 531 for example towards a sample.

The source conversion unit 506 may comprise an array of electron-optical components for operating on each beam or a group of beams of the plurality of beams. The source conversion unit 506 may include an image-forming element array 532 comprising an array of micro-deflectors configured to deflect the beams 521, 522, 523 towards the axis 510. The deflected beams 521, 522, 523 may form virtual images of the source crossover 514 on the sample 208.

The source conversion unit 506 may include an aberration compensator array 534 configured to compensate aberrations in the beams 521, 522, 523. The aberration compensator array 534 may be configured to compensate for field curvature and/or astigmatism for example.

The source conversion unit 506 may include a pre-bending micro-deflector array 533 configured to bend paths of the beams 521, 522, 523 upbeam of the beam-limiting aperture array 531, for example to cause paths of the beams 521, 522, 523 to be incident substantially perpendicularly onto the beam-limiting aperture array 531.

The image-forming element array 532, the aberration compensator array 534, and/or the pre-bending micro-deflector array 533 may comprise multiple layers of sub-beam manipulating devices, some of which may be in the form of arrays, for example: micro-deflectors, micro-lenses, and/or micro-stigmators.

In the example shown, the objective lens 508 comprises a magnetic lens that acts macroscopically on the beams to focus the beams onto the sample 208. In other embodiments, the objective lens 508 may comprise an objective lens array implemented electrostatically, or a combination of magnetic and electrostatic lenses may be used; for example a macro magnetic objective lens with electrostatic elements.

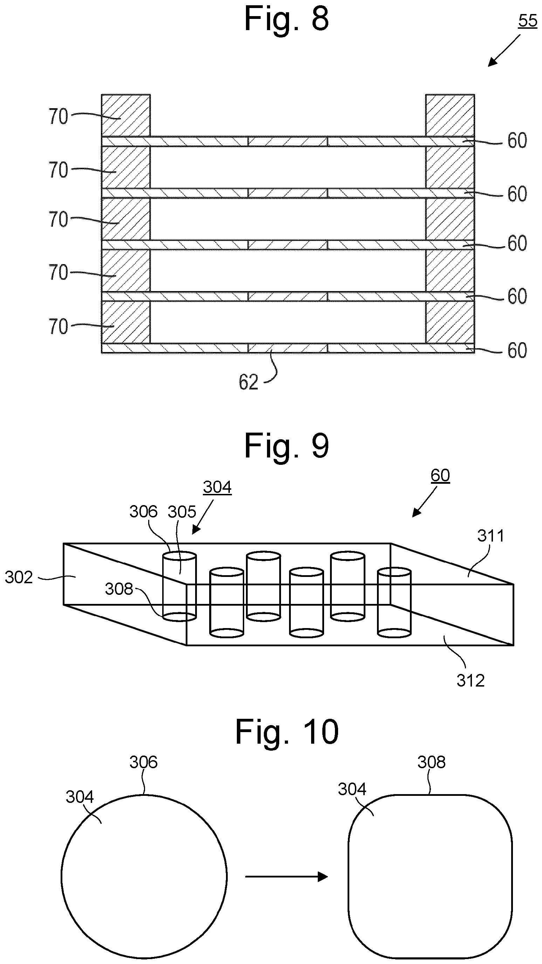

**FIG. 8** depicts an electron-optical module 55. The electron-optical module 55 may comprise an electron-optical stack. The electron-optical stack comprises a plurality of electron beam elements 60. The electron beam elements may comprise electron-optical plates. The electron-optical stack may form part of any of the electron-optical devices 41 disclosed herein, for example as described with reference to **FIG. 3**, **6** and **7**. The electron-optical stack may be provided as part of an assessment device for assessing a sample. The electron-optical stack may be, or form part of, an electron-optical lens assembly. The electron-optical lens assembly may comprise an objective lens array or assembly, or a condenser lens array or assembly, or may be an objective lens array or assembly, or a condenser lens array or assembly. Additionally or alternatively, the electron-optical stack may be or form part of, for example as a respective array, a collimator, a corrector such as an individual beam corrector, a detector array, a deflector and/or one or more elements of a Wien filter array. For example in an embodiment shown in and described with reference to **FIG. 3**, the stack 55 may comprise detector module 402, objective lens array 401, and control lens array 250. In an embodiment shown in and described with reference to **FIG. 7** the stack may comprise at least part of the source conversion module 506. That is the electron-optical module 55 may comprise, or may even be, a source conversion module 506.

The electron-optical module 55 is configured to direct charged particles along at least one beam path towards a sample location. In the orientation shown in **FIG. 8**, the at least one beam path extends vertically from top to bottom through the middle of the electron-optical stack. There may be one beam path corresponding to one charged particle beam. Alternatively, there may be a plurality of beam paths corresponding to a plurality of charged particle beams of a multi-beam.

In the example of **FIG. 8**, the electron-optical module 55 comprises a plurality of planar elements arranged across the beam path. In an embodiment one or more of the planar elements is an electron beam element 60 in the form of an electron-optical plate. The electron beam element 60 is configured to operate on the one or more electron beams. As shown in **FIG. 8**, in an embodiment all of the planar elements are electron beam elements 60. Alternatively, one or more of the planar elements may be a planar element other than an electron-optical plate. For example, one or more of the planar elements may be an element that is not required to have a voltage applied to it to perform its function, or the planar element is required to have a voltage applied to it so there is substantially zero potential difference between the element and an adjacent element along the beam path. One example is a planar element that is a beam limiting aperture array comprising apertures dimensioned to shape the charged particle beams. For example, the apertures may allow charged particle beams of a particular shape to pass through, while blocking other charged particles from propagating through the beam limiting aperture array. As a further alternative, a planar element configured to shape the charged particle beams may also have a potential difference with respect to an upbeam and/or downbeam planar element such that the electromagnetic field affects the charged particle beams in addition to the beam shaping function. In an embodiment one or more of the planar elements may be a detector such as a detector array.

As shown in **FIG. 8**, in an embodiment the electron-optical module 55 comprises one or more spacers 70. The spacers 70 are configured to mechanically support the planar elements. As shown in **FIG. 8**, in an embodiment a spacer 70 is configured to mechanically separate planar elements such as electron beam elements from each other. In an embodiment the spacers 70 are configured to electrically isolate planar elements such as electron beam elements 60 from each other. However, it is not essential for the spacers 70 to provide electrical isolation. For example, it may be that two adjacent electron beam elements 60 are arranged to be operated at the same voltage (i.e. having no potential difference between them), in which case electrical isolation may not be required. In an embodiment one or more pairs of adjacent planar elements are directly joined to each other, i.e. without an intermediate spacer 70. The spacers 70 are optional features. In a different arrangement, the spacer 70 may take the form of a conductive plate set to a ground potential in which are defined apertures positioned to correspond to the apertures through the plates of the adjoining beam elements. The surface of the apertures are conductive, including through the plate. The plate may consist of a conductive material or have a conductive coating. The adjoining beam elements are spaced apart from the spacer 70. They may comprise a similar plate to the spacer but with conductive surface over and around the aperture that is isolated from the plate as one or more electrodes. The electrodes may be individually controllable.

In an embodiment, the electron-optical module 55 is configured so that the charged particle beams pass through a beam area 62 of the electron-optical module 55. As shown in **FIG. 8**, the beam area 62 may be in a central portion of the electron-optical module 55. The beam area 62 is located generally centrally when viewed in a direction parallel to the at least one beam path. The beam area 62 is located centrally when viewed in a direction orthogonal to the plane of the planar elements. It is noted that in an embodiment in one or more of the electron beam elements 60 may be a single macro aperture. Such a macro aperture may be positioned to correspond to the beam area of another of the electron beam elements 60. Such a stack with a macro aperture may be or comprise a condenser lens array 231 as shown in and described with reference to **FIG. 3** **and** **6**. In an arrangement, the one or more of the electron beam elements 60 may comprise a plurality of apertures (or meso apertures) corresponding to groups of beam paths in the beam area. A stack comprising one or more plates with meso-apertures may comprise a Wien filter array 95.

In an embodiment the electron-optical module 55 is comprised in an electron-optical device 41, for example an electron-optical device 41 as shown in **FIG. 3**, **FIG. 6**, or **FIG. 7**. In an embodiment the electron-optical module 55 is field replaceable. The electron-optical module 55 may be removed from and/or inserted into the electron-optical device 41, without requiring any substantial dismantling of other parts of the electron-optical device 41. That is the electron-optical module 55 may be removable from and/or insertable into the electron-optical device 41.

As described above, electron beam elements 60 (e.g., electron-optical plates) may be configured to act as electrodes, for example as part of an objective lens array. Geometric features of the electron beam elements 60 allow charged particle beams to pass through the electron beam elements 60. Such features include apertures (which may also be referred to as channels or through-holes) through substrates of the electron beam elements 60 and openings defined in surfaces of the substrates (at each end of each aperture). Electric fields adjacent to openings associated with the apertures may apply a lensing effect to the charged particles. In some arrangements, the apertures may be adapted to compensate for aberrations, for example for off-axis aberrations in a multi-beam such as distortion, focus curvature, astigmatism and coma. For example, the apertures of one or more of the electrodes may be shaped, sized and/or positioned to compensate for off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example US 2023/0290609 A1, which is hereby incorporated by reference so far as off-axis aberration correction.

Performance of electron beam elements such as electron-optical plates may be highly sensitive to variations in properties of apertures such as their shapes, sizes and/or positions, particularly where these features are deliberately configured to correct for aberrations.

**FIG. 9** schematically depicts an example substrate 302 of an electron beam element 60. A plurality of apertures 304 are defined in the substrate 302. The apertures 304 are for passage of respective beams through the apertures 304. Each aperture 304 comprises an entrance opening 306 and an exit opening 308. The entrance opening 306 is defined in a first surface 311 of the substrate 302. The exit opening 308 is defined in a second surface 312 of the substrate 302. The first surface 311 and the second surface 312 are on opposite sides of the substrate 302.

As mentioned in the introductory part of the description, errors during manufacture of apertures 304 in substrates 302 for electron-optical systems (e.g., substrates of electron beam elements 60 such as electron-optical plates) can affect electron-optical performance, such as by introducing one or more aberrations to respective beams of the beam grid. The apertures 304 may be formed for example as channels 305 in the substrate 302 that have geometrical characteristics that affect electron-optical performance. Relevant geometrical characteristics may include a profile of an interior surface of the aperture 304, such as a cross-sectional shape of the aperture 304 at one or more positions along an axis of the aperture. For example, the shape of one or both openings of the aperture 304 may affect electron-optical performance. The openings of the aperture 304 may be referred to as an entrance opening 306 and an exit opening 308, as a start opening and an end opening, or as a first opening and a second opening. The channel 305 may be defined by a radially inward facing surface of the substrate 302 between the entrance opening 306 and the exit opening 306 of the aperture 304. Each aperture 304, for example the entrance opening 306 and/or exit opening 308, may act as a beam shaping element to control the shape and/or path of an electron beam. The effect of an aperture 304 on an electron beam is dependent on the shape of the aperture 304 around the electron beam (e.g., the shape of a surface of the substrate forming the aperture 304, such as the shape of the surface of the substrate 302 that defines and faces into the channel 305 and/or the shape of a surface defining the entrance opening 306 and/or of a surface defining the exit opening 308). The shape around the electron beam refers to the position of every point constituting the surface of the substrate 302 defining the aperture 304 with respect to the electron beam. Even small deviations in a form of the aperture 304 can lead to significant unwanted influences on the electron beam, leading for example to aberrations and/or reductions in electron-optical performance.

Apertures in substrates 302 may be manufactured using techniques from microelectromechanical system (MEMS) (i.e. using MEMS manufacturing techniques). The apertures 304 may be formed by etching a channel 305 through the substrate 302 from one side of the substrate 302 to an opposite side of the substrate 302. The etching process may be implemented using CMOS technologies such as lithography and deep reactive ion etching for example and other such processing techniques.

A target cross-sectional shape of an entrance opening 306 of the aperture 304 may be defined by lithography on a first surface 311 of the substrate 302. An etching process etches the aperture 304 through the substrate 302 to an exit opening 308 on a second side 312 of the substrate 302. Despite great care being taken to ensure that the cross-section of the aperture 304 remains constant as a function of depth during the etch, small deviations are observed in practice. For example, as depicted in **FIG.10**, it has been observed that when a lithography process defines a circular entrance opening 306 (shown on the left in **FIG. 10**) imperfections in the etching process result in a non-circular exit opening 308 (shown on the right in **FIG. 10**). The deviation from circularity observed in the exit opening 308 may comprise a perturbation component that depends on the crystallographic symmetry of the substrate 302, as discussed in further detail below. Embodiments of the present disclosure aim to address these challenges.

An electron-optical system may be provided. The electron-optical system may comprise or be comprised by an assessment system 100 as described above with reference to **FIG. 1**. The electron-optical system may comprise or be comprised by an electron beam apparatus 40 as described above with reference to **FIG. 2**. The electron-optical system may comprise or be comprised by an electron-optical device 41 as described above with reference to **FIG. 3-7**. The electron-optical system is for projecting one or more electron beams towards a sample 208. The electron-optical system comprises an electron beam element 60 for operating on the one or more electron beams. The electron beam element 60 may comprise a substrate 302 as described above with reference to **FIG. 9**.

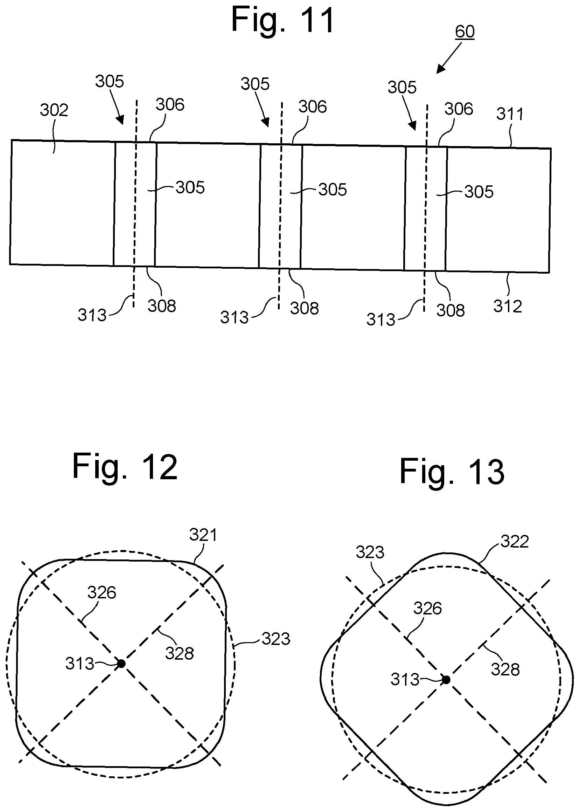

Reference is now made to **FIG. 11**, which is a schematic side sectional view of a portion of an example substrate 302 of an electron beam element 60. At least one aperture 304 is defined in the substrate 302. The aperture 304 has an entrance opening 306 and an exit opening 308 on opposite sides of the substrate 302. The aperture 304 may comprise a channel 305. The channel 305 provides a radially inward facing surface between the entrance opening 306 and the exit opening 308. In the example shown, a plurality of apertures 304 are defined in the substrate 302. Each aperture 304 is configured to allow an electron beam corresponding to the aperture 304 to pass through the aperture 304. In embodiments in which the electron-optical system uses a plurality of electron beams, each beam may pass through a different respective one of the apertures 304. Plural substrates 302 may be provided in series. Apertures 304 in different substrates 302 may be aligned with each other along respective different beam paths. A surface in which an opening of the aperture 304 is defined, such as the first surface 311 (in which an entrance opening 306 is defined in the example of **FIG. 11**) or the second surface 312 (in which an exit opening 308 is defined in the example of **FIG. 11**), may comprise one or more electrodes. The one or more electrodes may be configured to apply a lensing effect defined by the geometry of the aperture 304 and an electric field generated by the one or more electrodes (in combination with other electrodes spaced apart from the one or more electrodes to define a potential difference).

Each aperture 304 has an aperture axis 313 associated with the aperture 304. The aperture axis 313 is typically perpendicular to the substrate 302. The aperture axis 313 may at least be perpendicular to a portion of the first surface 311 in which the entrance opening 306 of the aperture 304 is defined (e.g., a portion of the first surface 311 that surrounds the entrance opening 306 and/or adjoins the entrance opening 306). Typically, the substrate 304 is substantially planar. The aperture axis 313 may thus be perpendicular to most or all of the first surface 311 and most or all of the second surface 312. The aperture axis 313 may correspond to an axis of rotational symmetry of the aperture 304. For example, where the aperture 304 is substantially cylindrical, the aperture axis 313 may correspond to the axis of cylindrical symmetry.

Embodiments of the disclosure aim to reduce the effect of imperfections in processing techniques, such as an etching process, used to form the apertures 304 and/or to reduce demands on such processing techniques. Typically, the effect of imperfections in an etching process on the precision with which entrance and exit openings of an aperture 304 can be made is larger for deeper apertures. Depth in this context refers to the separation along an aperture axis 313 between the entrance opening 306 and the exit opening 308 of the aperture 304. The depth may correspond to the length of the channel 305 of the aperture 304, for example between the extremities of the aperture 304, for example between the entrance opening 306 and the exit opening 308. Embodiments of the disclosure are thus particularly applicable for apertures 304 that are relatively deep. In an embodiment, the aperture 304 has a depth along the aperture axis 313 of at least 10 microns, optionally at least 50 microns, optionally at least 100 microns. The aperture 304 may also be thinner, such as less than 5 microns or less than 2 microns. The aperture 304 may also be thicker, such as up to 400 microns or 500 microns or higher. The depth of the aperture 304 may also be selected to have a value that is not too large, to avoid excessive overall distortion of the entrance opening 306 and/or the exit opening 308 relative to a target shape.

A cross-section of the entrance opening 306 across (e.g., perpendicular to) the aperture axis 313 has an entrance shape 321 (which, as described below, may correspond to a start shape or an end shape of an etching process, depending on the orientation of the substrate 302 in an electron-optical system). An example of an entrance shape 321 is shown in **FIG. 12**. The cross-section of the entrance opening 306 across (e.g., perpendicular to) the aperture axis 313 is the cross-section as it would appear viewed along the aperture axis 313, such as downwards within the plane of the page in the orientation of **FIG.11**. In an embodiment of the present disclosure, the entrance shape 321 is distorted relative to a target shape 323 (see **FIG. 12** and **13** for example). When the entrance shape 321 corresponds to a start shape of an etching process, the distortion of the entrance shape 321 may be deliberately applied, for example by a correspondingly shaped mask in a lithography process, as described below.

A cross-section of the exit opening 308 across (e.g., perpendicular to) the aperture axis 313 has an exit shape 322 (which, as described below, may correspond to an end shape or a start shape of an etching process, depending on the orientation of the substrate 302 in an electron-optical system). An example of an exit shape 322 is shown in **FIG. 13**. In an embodiment, the exit shape 322 is distorted relative to the target shape 323. Thus, the entrance shape 321 and the exit shape 322 are both distorted relative to the same target shape 323. As will be described below, the distortion of the entrance shape 321, when corresponding to the start shape in an etching process, is applied so that the distortion of the exit shape 322 will be smaller than it would have been without the distortion of the entrance shape 321. Thus, an impact by the entrance shape and the exit shape on the characteristics of a beam propagating through the entrance shape and the exit shape may be reduced by having both the entrance shape and the exit shape bear the distortion instead of only one of the entrance shape and the exit shape (e.g., the exit shape only).

Embodiments of the present disclosure may be provided in the form of a method for manufacturing an electron beam element comprising such a substrate 302. The method may comprise etching at least one aperture 304 in the substrate 302 so that the aperture 304 has any of the forms described herein. The etching is configured to remove material progressively from one side of the substrate 302 (e.g., the first side 311 of the substrate 302 shown in **FIG. 11**) to the other side of the substrate 302 (e.g., the second side 312 of the substrate 304 shown in **FIG. 11**) to define a start opening and an end opening. Both of the start and end openings (which are defined relative to the direction of etching) can operate as either entrance or exit openings (which are defined relative to a direction of propagation of a beam through the aperture 304). In the examples described below, the entrance opening 306 (which defines where the beam enters the aperture 304) is provided by the start opening (which defines where the etching process starts) and the exit opening 308 (which defines where the beam exits the aperture 304) is provided by the end opening (which defines where the etching process ends). However, it will be understood that the substrate 302 of the electron beam element 60 can be oriented in either sense when used in an electron-optical system. Thus, as an alternative to any of the embodiments described below, the exit opening can be provided by the start opening instead of by the end opening and the entrance opening can be provided by the end opening instead of the start opening (e.g., by the substrate 302 being oriented in the electron-optical system so that the end opening is up beam of the start opening instead of down beam of the start opening).

In an embodiment, the target shape 323 is the same for two or more, optionally for all, of the apertures 304 in a substrate 302 having a plurality of the apertures 304. The target shape 323 may comprise a portion of, a majority of, or all of, one or more of the following: a circle, an ellipse, a polygon, and a regular shape. Thus, the target shape 323 may be a circle, an ellipse, a polygon and/or a regular shape. A regular shape is a shape for which all sides are equal and all inside angles are equal. The polygon is optionally a quadrilateral (e.g., square or rectangle). The polygon may be a regular polygon, such as an equilateral triangle or a square. The target shape 323 may be selected according to electron-optical requirements of the electron beam element 60. As mentioned above, these requirements may include correction of aberrations. The correction of aberrations may be performed using different shapes of aperture for different charged particle beams. In an embodiment, such a correction will typically be smaller than 1% and commonly less than 0.1% of the dimension of the aperture (e.g., a diameter of the aperture). The target shape 323 may thus be different for different apertures 304, for example different apertures 304 in an array of apertures in the substrate 302. The difference in target shape may be dependent on one or more of the position of an aperture in the array relative to other apertures in the array, the center of the array and the center of the grid of beams through the different apertures (or the electron-optical axis of the beam grid). Arranging for both of the entrance opening 306 and exit opening 308 to be distorted relative to the same target shape 323 thus contrasts with the situation described above with reference to **FIG. 10**. In that situation, a target shape 323 was a circle and only the exit opening 308 (provided by an end opening in an etching process) was distorted relative to a circle.

The inventors have recognized that deviations from the target shape 323 caused by imperfections in the etching process have a predictable form. The predictable form may, for example, comprise a relative elongation of a cross-section of the aperture 304 along one or more directions. This may be caused by faster etching along those directions than along other directions. By selecting the entrance shape 321 (e.g., provided by a start shape in an etching process) to be distorted relative to the target shape 323 in an opposite sense to the expected distortion it is possible to share the distortion between the entrance opening 306 and the exit opening 308. In this way, a maximum deviation from the target shape 323 is lower than would have been the case if the distortion had not been shared. For example, the exit shape 322 can be closer to the target shape 323 than would have been the case if the entrance shape 321 had not been distorted relative to the target shape 323 (e.g., in the case of the target shape being a circle, the exit shape 322 would be closer to a circle than if the entrance shape 321 had been formed to be as close to a perfect circle as is possible with a lithography process used to define the entrance shape 321).

Based on the above insight, in an embodiment a start shape (e.g., the entrance shape 321 or the exit shape 322) and an etching process are configured such that the entrance shape 321 and the exit shape 322 have the following property: the entrance shape 321 and the exit shape 322 comprise deviations relative to the target shape 323 that are opposite in sign along at least one direction perpendicular to the aperture axis 313. Such an embodiment may occur when the entrance shape 321, the exit shape 322, and the target shape 323 are scaled to have the same cross-sectional area as each other.

Alternatively or additionally, an azimuthal distortion function may be used to describe a shape of the cross-section of the aperture 304 by reference to how the shape deviates from the target shape as a function of azimuthal angle (or rotational angle around the aperture axis 313) at each axial position along the aperture axis 313. A variation of the azimuthal distortion function with position along the aperture axis 313 may describe how the cross-section of the aperture 304 varies as a function of position along the aperture axis 313. The variation of the azimuthal distortion function along the aperture axis 313 may be seen as defining the shape of the channel 305 in a cylindrical coordinate system. For a given position along the aperture axis 313, the azimuthal distortion function may define an operation on a radial parameter of the target shape along each azimuthal direction (which may also be referred to as a radial direction). Each azimuthal direction points away from the aperture axis 313 in a direction defined by a respective azimuthal angle. The operation on the radial parameter of the target shape along each azimuthal direction may define a radial deviation from the target shape along the respective azimuthal direction. The operation on the radial parameter of the target shape may vary as a function of azimuthal angle around the aperture axis 313 to define the shape of the cross-section of the aperture 304. Thus, the radial deviation from the target shape may be different along different azimuthal directions. The azimuthal distortion function thus defines a deviation as a function of azimuthal angle between the shape of the cross-section and the target shape. This may be expressed as: a deviation of a radial coordinate (deltaR) of a cross-sectional shape (e.g., a deviation from a circle) as a function of the azimuthal angle (i.e., deltaR(theta)).

A consequence of the azimuthal distortion function varying as a function of position along the aperture axis 313 is that the radius of the cross-sectional shape at one or more rotational positions (or azimuthal positions) will also vary as a function of position along the aperture axis 313. In summary: the azimuthal distortion function may be considered to relate a radial distortion of a radial position on a periphery of a cross-sectional shape of the aperture as a function of rotational position (or azimuthal position) around the axis of the aperture, and a function of the position of the cross-section through the aperture axis i.e. along the aperture axis.

The start shape (e.g., entrance shape 321 or the exit shape 322) and the etching process may be configured such that the azimuthal distortion function varies along the aperture axis 313 in a way that achieves the desired effect of sharing the distortion relative to the target shape 323 between the entrance shape 321 and the exit shape 322. As described above, the azimuthal distortion function defines a deviation as a function of azimuthal angle between the shape of the cross-section and the target shape 323 (e.g., a difference in radial position at each azimuthal angle (or a difference in radial position dependent on azimuthal angle)).

The azimuthal distortion function may have an undulating form. The undulating form may be approximately sinusoidal for example. An amplitude of the azimuthal distortion function corresponds to an amplitude of a deviation in shape from the target shape 323. An amplitude of the azimuthal distortion function may vary as a function of position along the aperture axis 313 between the entrance opening 306 and the exit opening 308. The start shape (e.g., entrance shape 321 or exit shape 322) and etching process may be configured such that the azimuthal distortion function changes sign at a position between the entrance opening 306 and the exit opening 308, for example at a midpoint through the channel 305. The changing sign of the azimuthal distortion function may occur at least when the entrance shape 321, the exit shape 322, the target shape 323 and cross-sections of the aperture 304 are scaled to have the same cross-sectional area as each other.

As a function of depth from the entrance opening 306, the amplitude of the azimuthal distortion function may progressively decrease until the azimuthal distortion function changes sign and then progressively increase until the exit opening 308 is reached. At the point at which sign changes the cross-section of the aperture may have the target shape. The etching may thus apply an azimuthally varying distortion to the start shape (e.g., entrance shape 321) with progress towards the end shape (e.g., exit shape 322). In an embodiment the application of the azimuthally varying distortion to the start shape (e.g., entrance shape 321) with progress towards the target shape, for example progress through the target shape towards the end shape (e.g., exit shape 322). The entrance shape 321 and the exit shape 322 may be derived by application of the azimuthally varying distortion to the target shape 323 with opposite sign.

The amplitude of the azimuthal distortion function may be observed as the size of a radial deviation in the direction of the azimuthal position (or azimuthal angle or rotational position) of a point of the periphery of the shape away from the radius of the target shape in the corresponding direction, except for points at which the distortion has no perceived effect. Application of the azimuthal distortion function at an azimuthal position may result in a radial distortion that may be observed for the azimuthal position as a radial deviation (i.e. relative to the target shape). The radial deviation may vary, for example sinusoidally, as a function also of the azimuthal position around the aperture axis 313. The magnitude of the radial distortion of a point on the periphery at an azimuthal position may vary as a function of position along the aperture axis 313. At the point of changing sign, the radial distortion at all azimuthal positions around the aperture axis 313 is substantially zero. The radial deviation of a position on the periphery of the cross-sectional shape of the aperture 304 decreases in magnitude away from the entrance opening 306 until reaching an intermediate position (e.g., midpoint). The radial deviation increases in an opposite direction closer towards the exit opening 308. The radial deviation of a point of the perimeter (or periphery) of the cross-sectional shape axially varies for example between the entrance opening 306 and the exit opening 308. Such deviation may be dependent on the depth of the substrate, or the dimension of the channel to be etched between the entrance opening 306 (or entrance shape 321) and the exit opening (or exit shape 322).

The scaling of the shapes to have the same area may be referred to as normalizing the shapes. The normalization facilitates comparison between details of the shapes. Scaling of a shape is understood to mean multiplying every distance defining the shape by the same scale factor.

The deviations of the entrance shape 321 of the entrance opening and the exit shape 322 of the exit opening relative to the target shape 323 that are opposite in sign along at least one direction may be opposite in sign along directions corresponding to directions of faster etching. The start shape (e.g., entrance shape 321) may thus be arranged to have a radius that is slightly smaller than a target radius along the directions of faster etching to compensate for the etching being faster along those directions. Such an arrangement may mean that an average radius of the entrance shape in the case of a circular target shape 323 is smaller than that of the target radius to compensate for the etching being faster along the directions of faster etching. This may lead to the end shape (e.g., the exit shape 322) being less far away from a target radius along the directions of faster etching than would have been the case otherwise.

An example implementation is described with reference to **FIG. 12-15****.** **FIG. 12** depicts an example entrance shape 321 and an example target shape 323. The entrance shape 321 and target shape 323 are scaled to have the same cross-sectional area. **FIG. 13** depicts an example exit shape 322 and the target shape 323 of **FIG. 12**. The exit shape 322 is scaled in the same way as the entrance shape 321 and target shape 323 of **FIG. 12**. The scaled exit shape 322 thus has the same area as the target shape 323.

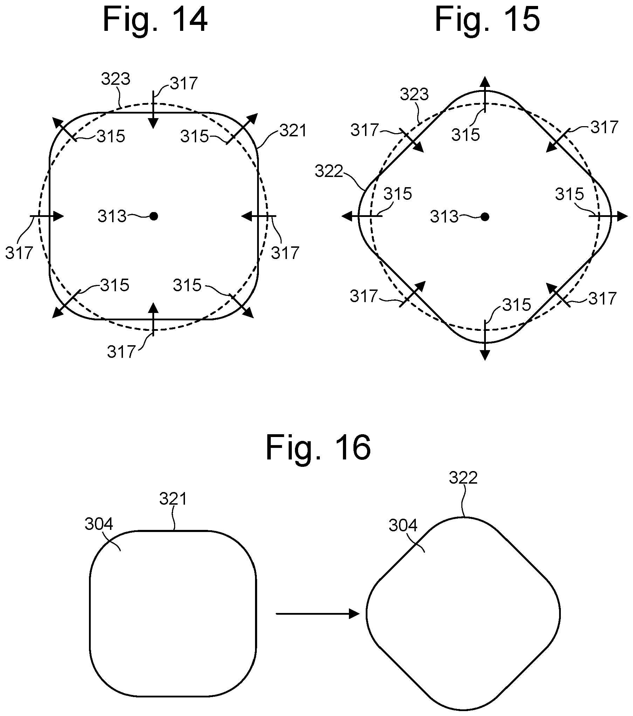

The entrance shape 321 of **FIG. 12** may be suitable for a case where etching is slower than average along a direction parallel to axis 326 (e.g., a radially outward direction) and slower than average along a direction parallel to axis 328 (e.g., a radially outward direction). In this example, etching results in the exit shape 322 being as shown in **FIG. 13**. Directions of deviations of the entrance shape 321 from the target shape 323 are depicted schematically in **FIG. 14**. Directions of deviations of the exit shape 322 from the target shape 323 are depicted schematically in **FIG. 15**. Example radially outward deviations are indicated by arrows 315 in **FIG. 14** and **15**. Example radially inward deviations are indicated by arrows 317 in **FIG. 14** and **15**. Deviations of the entrance shape 321 relative to the target shape 323 are radially outwards along axes 326 and 328, as indicated by outward arrows 315 in a radial outward direction. Deviations of the exit shape 322 relative to the target shape 323 are radially inwards along axes 326 and 328, as indicated by inward arrows 317 in a radially inward direction. The deviations of the entrance shape 321 relative to the target shape 323 are thus opposite in sign along the radial direction parallel to axis 326 compared to the deviations of the exit shape 322 relative to the target shape 323. So radially in different directions as shown by outward arrows 315 and inwards arrows 317. Similarly, deviations of the entrance shape 321 relative to the target shape 323 are opposite in sign along the radial direction parallel to axis 328 compared to the deviations of the exit shape 322 relative to the target shape 323. This is also shown by outward arrows 315 and inwards arrows 317. In this example, the axes 326 and 328 are perpendicular to each other. This effect may also be described in terms of a changing of sign of the azimuthal distortion function discussed above.

The above strategy may result in the entrance shape 321 and the exit shape 322 being non-circular shapes having a rotational symmetry of order *N,* where *N* is an integer equal to or greater than two. *N* may for example be four, which may apply a four-fold astigmatism to a beam propagating through the aperture 304. Alternatively, *N* may be six or any other value. Over-etching and/or under-etching in certain directions can be caused by a range of effects, including but not limited to etching preferences in certain crystal directions. Contributing factors may include features of etcher electrodes, non-uniform E-fields in an etcher apparatus, and/or symmetries of other features around the feature of interest (local etch effects). In some cases, apertures may be provided in a hexagonal grid. In such an arrangement, each beam may have six neighbors. Local etch effects (which may be referred to as local etch rate distortions) may cause an *N*=6 aberration in this case, which could be compensated for by biasing the start shape (e.g., entrance shape 321) with a corresponding symmetry. The sharing of the distortion relative to the target shape 323 between the entrance shape 321 and the exit shape 322 may result in *N* being the same for the entrance shape 321 and the exit shape 322. In cases where axes 326 and 328 of slowest etching (or axes of fastest etching) are perpendicular to each other, *N* may be four, as exemplified in **FIG. 12-15**.

In some embodiments, the entrance shape 321 and the exit shape 322 comprise substantially the same shape. This may arise when the entrance shape 321 and etching process are configured to share the distortion relative to the target shape 323 equally between the entrance shape 321 and the exit shape 322. In an embodiment, the entrance shape 321 and the exit shape 322 have the same shape and are rotated relative to each other about the aperture axis 313 by a rotation angle. The rotation angle is 180 degrees or less, such as 180/K, where K is an integer equal to or greater than 1. As exemplified in **FIG. 16**, the rotation angle may be 45 degrees. In the examples shown, the rotation is from a square-like orientation (**FIG. 16** left) to a diamond-like orientation (**FIG. 16** right). In other embodiments, the rotation may be from the diamond-like orientation to the square-like orientation. In other embodiments, the rotation angle may be different than 45 degrees. The rotation angle may depend on the crystallographic symmetry of the substrate 302 and the orientation of the crystal lattice relative to the plane of the substrate 302. The rotation angle may, for example, be 30 degrees instead of 45 degrees, for example where a crystallographic structure parallel to the plane of the substrate 302 has hexagonal symmetry. Alternatively, the rotation angle may be 90 degrees.

The above strategy may alternatively or additionally result in the end opening (e.g., exit opening 308) having a cross-sectional shape (e.g. exit shape 322) that is closer to the target shape than if the start opening (e.g., entrance opening 308) had a cross-sectional shape (e.g. entrance shape 321) that corresponds to the target shape. The above strategy distributes the distortion between the cross-sectional shapes of the entrance opening 306 and the exit opening 308. The above strategy may alternatively or additionally result in a shape of a cross-section of the aperture 304 being closer to the target shape 323 than either or both of the entrance shape 321 and the exit shape 322 at one or more, optionally all, positions along the aperture axis 313 between the entrance opening 306 and the exit opening 308. In some cases, the cross-section of the aperture 304 may become substantially equal to the target shape 323 at a cross-over position along the aperture axis 313 between the entrance opening 306 and the exit opening 308, for example at an intermediate point of the channel 305. Thus, the etching causes a variation in a shape of a cross-section of the aperture 304 as a function of position along the aperture axis 313. The variation may be such that, when scaled to have the same cross-sectional area as the target shape 323, an average radial deviation between the cross-section of the aperture 304 and the target shape 323 has a minimum at a position between the entrance opening 306 and the exit opening 308. The minimum may be substantially zero. The entrance shape 321 and etching process may thus be configured to share the distortion relative to the target shape 323 equally between the entrance shape 321 and the exit shape 323. In such a case, the cross-over position may be approximately half way between the entrance shape 321 and the exit shape 323; for example the cross-over position may be equidistant in the channel 305 between the entrance opening 306 and the exit opening 308. In a situation in which similar electric fields are located either side of the substrate the aberrational effect of the distortion may be configured to operate contrary to each other. In an arrangement in which the distortion is shared unequally between the entrance shape 321 and the exit shape 322, the cross-over position may be positioned elsewhere along a length of the channel 305, for example closer to the aperture with the least distortion. Such an arrangement may be suited to a situation in which the electric field strengths adjacent to the two major surfaces are different, for example such that the aberrational effect on a beam passing through the aperture 304 of the magnitude of the radial distortion of one of the two openings and the electrostatic field on one side of the plate may counteract the aberrational effect on the beam of the other of the two openings and the associated electrostatic field on the other side of the plate, even cancel.

In accordance with the above description, the following method may be provided. The method comprises etching an aperture 304 in a substrate 302 for passage of an electron beam through the aperture 304. The etching comprises removing material progressively from a start side of the substrate 304 at a first opening (which may correspond to the start opening and operate as the entrance opening 306 or the exit opening 308 in the examples above) with a start shape to an end side of the substrate at a second opening (which may correspond to the end opening and operate as the exit opening 308 or the entrance opening 306 in the examples above) with an end shape. The etching applies a radial distortion to the start shape with progress towards the second opening. The start shape and the end shape are derived by application of the radial distortion with opposite sign with respect to a target shape. The target shape may take any of the forms described above. The target shape may be circular, elliptical, polygon or a regular shape.

The etching comprises varying a size of the radial distortion of the start shape relative to the target shape with progress of the etching through the substrate 302. The radial distortion may comprise a radial deviation from the target shape along one or more rotational angles (which may be referred to as azimuthal angles) around an axis of the aperture. The radial deviation may be defined as a function of rotational angle around an axis of the aperture 304, for example such that the radial deviation varies as a function of rotational angle around the axis of the aperture 304. At a given rotational angle, the radial deviation may comprise a deviation relative to the target shape of a radial dimension of a peripheral portion of a cross sectional shape of the aperture at that rotational angle. The size of the radial distortion may be different for different rotational angles at any given axial position along the axis of the aperture 304. The applying of the radial distortion comprises varying the radial deviation as a function of axial position through the aperture 304. A radial dimension of the peripheral portion of the cross sectional shape of the aperture at one or more rotational angles may thereby vary as a function of axial position through aperture. In an embodiment, the applying of the radial distortion is such that the cross-sectional shape of the aperture 304 becomes substantially equal to the target shape at a position between the start side of the substrate 304 and the end side of the substrate 304.

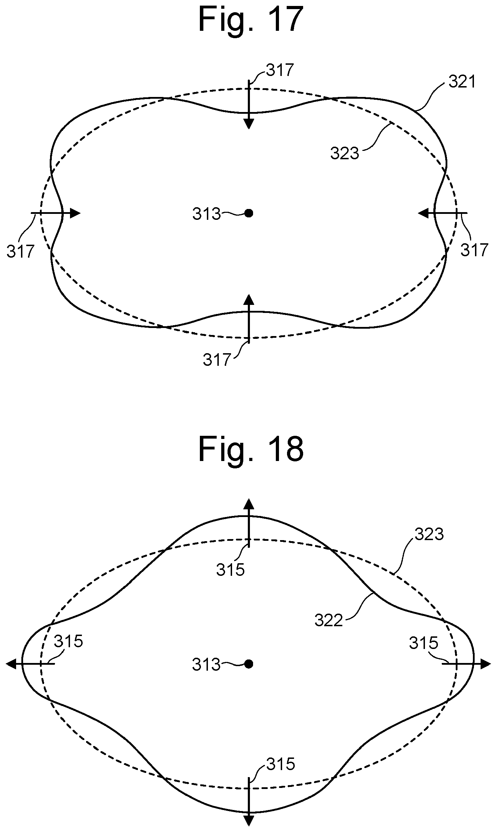

**FIG. 17** and **18** depict further examples of an entrance shape 321 and an exit shape 322 relative to a target shape 323. **FIG. 17** and **18** correspond to **FIG. 14** and **15** except that the target shape 323 in **FIG. 17** and **18** is an ellipse instead of a circle. Thus the application of the azimuthal distortion function may be applied to any shape of cross-sectional target shape 323 for an aperture. The radial distortion may be shared (although of opposite sign) between the entrance shape 321 and exit shape 322 of the aperture.

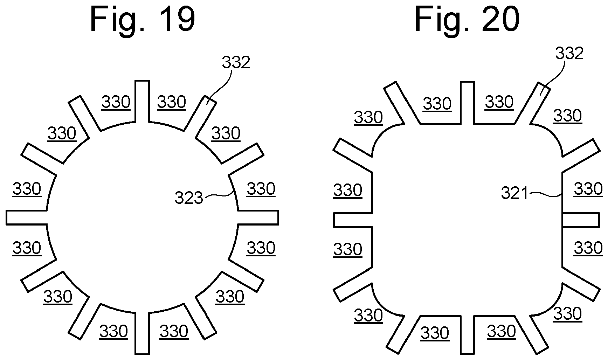

**FIG. 19** and **20** schematically depict a further embodiment in which the target shape 323 is not a complete circle, a complete ellipse, a complete polygon or a complete regular shape. As mentioned above, the target shape 323 may comprise only a portion of, or only a majority of, a circle, an ellipse, a polygon or a regular shape. The target shape may be based on a circle, an ellipse, a polygon or a regular shape, which may be defined with at least one rotational axis (e.g., axis of rotational symmetry), with variations which may take the form of perturbations such as periodic features (e.g., periodic as a function of angle around the rotational axis, such as with a regular angular separation around the rotational axis). In the example shown, as depicted in **FIG. 19**, the target shape 323 comprises a majority of a circle and periodic protrusions. The aperture 304 is defined in a surface (e.g., a first surface 311 or a second surface 312) in the substrate 302 for example through the substrate 302. The aperture may comprise an entrance opening on one side of the substrate and an exit opening on the other side of the substrate with a channel extending between the two openings. The surface may define a plurality of electrodes. The entrance shape 311 and the exit shape 322 may comprise a plurality of radial outward portions 332 (such as periodic protrusions), which in the body of the substrate 302 may take the form of recesses in the channel extending through the openings of the aperture 304. The plurality of radial outward portions 332 define regions 330 between the radial outward portions 332. A region 330 may be defined between adjoining radial outward portions 332. Adjoining regions 330 may define a respective radial outward portion 332 between them. Since the radial outward portions 332 are part of a cross-sectional shape of the aperture 304, it is understand that when such a target shape is defined in a substrate 302, the regions 330 may be considered as inward protrusions of the substrate 302 that protrude inwards towards the aperture axis 313 relative to the radial outward portions 332. The radial outward portions 332 are recesses defined between respective such adjoining inward protrusions. It is therefore understood that in the remaining text, reference to a region 330 is to an inward protrusion of the substrate material and the radial outward portions 332 are recesses defined between adjoining inward protrusions. A plurality of electrodes may be provided between the radial outward portions 332. For example an electrode may be defined between adjoining radially outward portions 332. The electrode may comprise at least part of a respective region 330. The electrodes may be electrically isolated from each other at least partly by the radial outward portions 332. Adjoining electrodes may therefore be isolated by an interleaving radial outward portion 332. The substrate 302 may have isolating material radially outward of the different regions 330 for example to ensure adjoining electrodes are isolated. The electrodes may be configured to apply lensing and/or deflecting and/or stigmation of an electron beam passing through the aperture 304. The electrodes may apply lensing and/or deflecting and/or stigmation to the electron beam. In embodiments of this type, at least the portion of the entrance shape 321 corresponding to a portion of a circle, a portion of an ellipse, a portion of a polygon or a portion of a regular shape may be distorted with a distortion relative to the circle, or ellipse, polygon or regular shape. The distortion is such that a distortion relative to the circle, ellipse polygon or regular shape caused by imperfections in an etching process for etching the aperture 304 through the substrate 302 is shared between the entrance shape 321 and the exit shape 322. Thus, as depicted schematically in **FIG. 20**, the portion of the entrance shape 321 corresponding to the circular part of the target shape 323 may be distorted relative to a circle in the same way as described above with reference to **FIG. 12** and **14** for example. In another arrangement the shape shown in **FIG. 20** may be the result of distorting a target shape by the radial distortion defined by the azimuthal distortion function, the azimuthal distortion function being thus applied to the shape depicted in **FIG. 19** to achieve the shape depicted in **FIG 20**.

The terms entrance opening and exit opening are terms of convenience. The terms may be defined with respect to the beam path or a processing technique used to form the apertures, such as etching direction. If the substrate in which the apertures are formed is turned over, an entrance opening may become an exit opening and vice versa. The terms entrance opening and exit opening when applied to a substrate independently of a beam path may simply refer to different openings of an aperture defined in opposite major surface of a substrate. An opening considered as an entrance opening in the context of manufacture (e.g., where an etching process starts and which may be referred to as a start opening) may or may not correspond to an opening considered as an entrance opening from the point of view of a beam path (e.g., where an electrode beam first enters the aperture).

Although the preferred embodiment referred to an arrangement in which the beam paths are collimated, that need not always be the case; for example the beam paths may be diverging or converging (so as to be aligned with corresponding apertures through the substrates). In a converging or diverging beam grid at least one of the beam paths is orthogonal to the plane of the electron beam element substrate. In an arrangement the beam paths may be controlled by electron-optical electrodes in one or more of the electron beam elements such as a multipole array in which surfaces of each of the apertures and/or at least one of the associated openings in the substrate comprises a plurality of apertures which may be controlled to deflect the paths of the beams relative to each other.

Although reference in this description is to an aperture extending through the entire thickness of a substrate, such an aperture or a grid of apertures may be comprised within a thinned region of the substrate. For example one or both of the openings of such an aperture or of each of the apertures in a grid may be defined in a recess in the surface of the substrate; thus one or both major surfaces of the substrate may be recessed.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the detector array 240.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field. The references to beam path are to the intended position of a corresponding beam during operation of the charged particle apertures. Such references when made in reference to an electron-optical element, such as an electrode plate, may be generally understood to relate, for a collimated beam path, to the optical axis of the beam and thus the orthogonal to the plane of the electron-optical element. In reference to an uncollimated beam, such as a divergent beam, the beam path may be considered to be relative to the axis of the mid-point of the beam, or the mid-point of beam grid when the beam is a beam of a beam grid. Therefore, although the orientation of the beam path may be considered an axis orthogonal to the plane of a planar electron-optical element, this may not always be the case; in some embodiments the beam path is angled (e.g., obliquely) relative to such a planar electron-optical element.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). It is appreciated that the invention may be applied to other types of apparatus such as a charged particle lithographic apparatus for use in generating patterns on a sample.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses.

Clause 1. An electron-optical system for projecting one or more electron beams towards a sample, the system comprising an electron beam element for operating on the one or more electron beams, wherein the electron beam element comprises: a substrate in which at least one aperture is defined for passage of a respective electron beam through the aperture, the aperture having an aperture axis, wherein: the aperture comprises an entrance opening and an exit opening on opposite sides of the substrate; a cross-section of the entrance opening across the aperture axis has an entrance shape, the entrance shape being distorted relative to a target shape; a cross-section of the exit opening across the aperture axis has an exit shape, the exit shape being distorted relative to the target shape; and when the entrance shape, the exit shape, and the target shape are scaled to have the same cross-sectional area as each other, the entrance shape and the exit shape comprise deviations relative to the target shape that are opposite in sign along at least one direction perpendicular to the aperture axis; and/or when the entrance shape, the exit shape, the target shape and cross-sections of the aperture are scaled to have the same cross-sectional area as each other, a cross-section of the aperture varies as a function of position along the aperture axis such that an azimuthal distortion function defining a shape of the cross-section changes sign at a position between the entrance opening and the exit opening, the azimuthal distortion function defining a deviation as a function of azimuthal angle between the shape of the cross-section and the target shape.

Clause 2. The system of clause 1, wherein the target shape comprises a portion of, a majority of, or all of, one or more of the following: a circle, an ellipse, a polygon, and a regular shape.

Clause 3. The system of clause 1 or 2, wherein the entrance shape and the exit shape are non-circular shapes having a rotational symmetry of order *N,* where *N* is an integer equal to or greater than two, optionally equal to four or six.

Clause 4. The system of any preceding clause, wherein the entrance shape and the exit shape comprise substantially the same shape and are rotated relative to each other about the aperture axis by a rotation angle, the rotation angle being 180/*K* degrees, where *K* is an integer equal to or greater than 1.

Clause 5. The system of clause 4, wherein the rotation angle is about 30 degrees, about 45 degrees, or about 90 degrees.

Clause 6. The system of any preceding clause, wherein a shape of a cross-section of the aperture is closer to the target shape than either or both of the entrance shape and the exit shape at one or more, optionally all, positions along the aperture axis between the entrance opening and the exit opening.

Clause 7. The system of any preceding clause, wherein a surface defining the aperture comprises one or more electrodes, the one or more electrodes optionally being configured to apply lensing to the electron beam.

Clause 8. The system of clause 7, wherein the surface defines a plurality of electrodes, desirably the exit shape comprising a plurality of radial outward portions desirably between different electrodes, desirably for lensing and/or deflecting and/or stigmation of the electron beam.

Clause 9. The system of any preceding clause, wherein the one or more electron beams comprises a plurality of electron beams and the substrate comprises a corresponding plurality of the apertures.

Clause 10. The system of any preceding clause, wherein the substrate is substantially planar.

Clause 11. The system of any preceding clause, wherein the aperture has a depth along the aperture axis of greater than 10 microns.

Clause 12. A method of manufacturing an electron beam element for operating on one or more electron beams of an electron-optical system, the method comprising: etching at least one aperture in a substrate for passage of a respective electron beam through the aperture, the aperture having an aperture axis, wherein the etching is configured to remove material progressively from a first side of the substrate to a second side of the substrate to define a respective start opening and end opening of the aperture, wherein: a cross-section of the start opening across the aperture axis has a start shape, the start shape being distorted relative to a target shape; a cross-section of the end opening across the aperture axis has an end shape, the end shape being distorted relative to the target shape; and when the start shape, the end shape, and the target shape are scaled to have the same cross-sectional area as each other, the start shape and the end shape comprise deviations relative to the target shape that are opposite in sign along at least one direction perpendicular to the aperture axis; and/or when the start shape, the end shape, the target shape and cross-sections of the aperture are scaled to have the same cross-sectional area as each other, a cross-section of the aperture varies as a function of position along the aperture axis such that an azimuthal distortion function defining a shape of the cross-section changes sign at a position between the start opening and the end opening, the azimuthal distortion function defining a deviation as a function of azimuthal angle between the shape of the cross-section and the target shape.

Clause 13. The method of clause 12, wherein the target shape comprises a portion of, a majority of, or all of, one or more of the following: a circle, an ellipse, a polygon, and a regular shape.

Clause 14. The method of clause 12 or 13, wherein the start shape and the end shape are non-circular shapes having a rotational symmetry of order *N,* where *N* is an integer equal to or greater than two, optionally equal to four or six.

Clause 15. The method of any of clauses 12 to 14, wherein the start shape and the end shape comprise substantially the same shape and are rotated relative to each other about the aperture axis by a rotation angle, the rotation angle being 180/*K* degrees, where *K* is an integer equal to or greater than 1.

Clause 16. The method of clause 15, wherein the rotation angle is about 30 degrees, about 45 degrees, or about 90 degrees.

Clause 17. The method of any of clauses 12 to 16, wherein the aperture has a depth along the aperture axis of greater than 10 microns.

Clause 18. The method of any of clauses 12 to 17, wherein the etching causes a variation in a shape of a cross-section of the aperture as a function of position along the aperture axis.

Clause 19. The method of clause 18, wherein the variation is such that, when scaled to have the same cross-sectional area as the target shape, an average radial deviation between the cross-section of the aperture and the target shape has a minimum at a position between the start opening and the end opening, the minimum optionally being substantially zero.

Clause 20. The method of any of clauses 12 to 19, wherein an amplitude of the azimuthal distortion function varies as a function of position between the start opening and the end opening.

Clause 21. A method of projecting one or more electron beams towards a sample, the method comprising using the electron-optical system of any of clauses 1 to 11.

Clause 22. A method of manufacturing an electron beam element for operating on one or more electron beams of an electron-optical system, the method comprising: etching an aperture in a substrate for passage of an electron beam through the aperture, wherein the etching comprises removing material progressively from a start side of the substrate at a first opening with a start shape to an end side of the substrate at a second opening with an end shape, the etching applying a radial distortion to the start shape with progress towards the second opening, wherein the start shape and the end shape are derived by application of the radial distortion with opposite sign with respect to a target shape, the target shape being optionally circular, elliptical, a polygon, and/or a regular shape.

Clause 23. The method of clause 22, wherein the etching comprises varying a size of the radial distortion of the start shape relative to the target shape with progress of the etching through the substrate.

Clause 24. The method of clause 22 or 23, wherein the radial distortion comprises a radial deviation from the target shape along one or more rotational angles around an axis of the aperture.

Clause 25. The method of clause 24, wherein the applying of the radial distortion comprises varying the radial deviation as a function of axial position through the aperture such that a radial dimension of a peripheral portion of a cross sectional shape of the aperture at one or more rotational angles varies as a function of axial position through aperture.

Clause 26. The method of clause 25, wherein the applying of the radial distortion is such that the cross-sectional shape of the aperture becomes substantially equal to the target shape at a position between the start side of the substrate and the end side of the substrate.

## Claims

1. An electron-optical system for projecting one or more electron beams towards a sample, the system comprising an electron beam element for operating on the one or more electron beams, wherein the electron beam element comprises:
a substrate in which at least one aperture is defined for passage of a respective electron beam through the aperture, the aperture having an aperture axis, wherein:
the aperture comprises an entrance opening and an exit opening on opposite sides of the substrate;
a cross-section of the entrance opening across the aperture axis has an entrance shape, the entrance shape being distorted relative to a target shape;
a cross-section of the exit opening across the aperture axis has an exit shape, the exit shape being distorted relative to the target shape; and
when the entrance shape, the exit shape, and the target shape are scaled to have the same cross-sectional area as each other, the entrance shape and the exit shape comprise deviations relative to the target shape that are opposite in sign along at least one direction perpendicular to the aperture axis;

2. The system of claim 1, when the entrance shape, and cross-sections of the aperture are scaled to have the same cross-sectional area as each other, a cross-section of the aperture varies as a function of position along the aperture axis such that an azimuthal distortion function defining a shape of the cross-section changes sign at a position between the entrance opening and the exit opening, the azimuthal distortion function defining a deviation as a function of azimuthal angle between the shape of the cross-section and the target shape.

3. The system of claim 1 or 2 , wherein the target shape comprises a portion of, a majority of, or all of, one or more of the following: a circle, an ellipse, a polygon, and a regular shape.

4. The system of claim 1, 2 or 3, wherein the entrance shape and the exit shape are non-circular shapes having a rotational symmetry of order *N,* where *N* is an integer equal to or greater than two, optionally equal to four or six.

5. The system of any preceding claim, wherein the entrance shape and the exit shape comprise substantially the same shape and are rotated relative to each other about the aperture axis by a rotation angle, the rotation angle being 180/*K* degrees, where *K* is an integer equal to or greater than 1.

6. The system of claim 5, wherein the rotation angle is about 30 degrees, about 45 degrees, or about 90 degrees.

7. The system of any preceding claim, wherein a shape of a cross-section of the aperture is closer to the target shape than either or both of the entrance shape and the exit shape at one or more, optionally all, positions along the aperture axis between the entrance opening and the exit opening.

8. The system of any preceding claim, wherein a surface defining the aperture comprises one or more electrodes, the one or more electrodes optionally being configured to apply lensing to the electron beam.

9. The system of claim 8, wherein the surface defines a plurality of electrodes, desirably the exit shape comprising a plurality of radial outward portions desirably between different electrodes, desirably for lensing and/or deflecting and/or stigmation of the electron beam.

10. The system of any preceding claim , wherein the one or more electron beams comprises a plurality of electron beams and the substrate comprises a corresponding plurality of the apertures.

11. The system of any preceding claim , wherein the substrate is substantially planar.

12. The system of any preceding claim , wherein the aperture has a depth along the aperture axis of greater than 10 microns.

13. A method of manufacturing an electron beam element for operating on one or more electron beams of an electron-optical system, the method comprising:
etching at least one aperture in a substrate for passage of a respective electron beam through the aperture, the aperture having an aperture axis, wherein the etching is configured to remove material progressively from a first side of the substrate to a second side of the substrate to define a respective start opening and end opening of the aperture, wherein:
a cross-section of the start opening across the aperture axis has a start shape, the start shape being distorted relative to a target shape;
a cross-section of the end opening across the aperture axis has an end shape, the end shape being distorted relative to the target shape; and
when the start shape, the end shape, and the target shape are scaled to have the same cross-sectional area as each other, the start shape and the end shape comprise deviations relative to the target shape that are opposite in sign along at least one direction perpendicular to the aperture axis.

14. The method of claim 13, when the start shape, the end shape, the target shape and cross-sections of the aperture are scaled to have the same cross-sectional area as each other, a cross-section of the aperture varies as a function of position along the aperture axis such that an azimuthal distortion function defining a shape of the cross-section changes sign at a position between the start opening and the end opening, the azimuthal distortion function defining a deviation as a function of azimuthal angle between the shape of the cross-section and the target shape.

15. The method of claim 13 or 14, wherein the start shape and the end shape comprise substantially the same shape and are rotated relative to each other about the aperture axis by a rotation angle, the rotation angle being 180/*K* degrees, where *K* is an integer equal to or greater than 1.
